(19) **Europäisches Patentamt / European Patent Office / Office européen des brevets**

(11) **EP 3 126 854 B1**

(12) **FASCICULE DE BREVET EUROPEEN**

(45) Date de publication et mention de la délivrance du brevet:
**21.06.2017 Bulletin 2017/25**

(21) Numéro de dépôt: **15719788.0**

(22) Date de dépôt: **27.03.2015**

(51) Int Cl.:
*G01R 27/20* (2006.01)  *G01R 19/25* (2006.01)
*G01R 21/133* (2006.01)

(86) Numéro de dépôt international:
**PCT/FR2015/050792**

(87) Numéro de publication internationale:
**WO 2015/150670 (08.10.2015 Gazette 2015/40)**

(54) **PROCEDE DE MESURE DE LA CONSOMMATION ENERGETIQUE DES BRANCHES D'UN RESEAU ELECTRIQUE ET EQUIPEMENT DE MESURE METTANT EN OEUVRE LEDIT PROCEDE**

VERFAHREN ZUR MESSUNG DES ENERGIEVERBRAUCHS DER VERZWEIGUNGEN EINES ELEKTRISCHEN NETZWERKS UND MESSVORRICHTUNG ZUR IMPLEMENTIERUNG DES VERFAHRENS

METHOD OF MEASURING THE ENERGY CONSUMPTION OF THE BRANCHES OF AN ELECTRICAL NETWORK AND MEASUREMENT EQUIPMENT IMPLEMENTING SAID METHOD

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **01.04.2014 FR 1452851**

(43) Date de publication de la demande:
**08.02.2017 Bulletin 2017/06**

(73) Titulaire: **Socomec S.A.**
**67230 Benfeld (FR)**

(72) Inventeurs:
• **CAPOT, Marc**
**F-67600 Kintzheim (FR)**

• **KERN, Christian**
**F-68240 Sigolsheim (FR)**

(74) Mandataire: **Koelbel, Caroline**
**Cabinet Nithardt et Associés**
**CS 91455**
**68071 Mulhouse Cedex (FR)**

(56) Documents cités:
**EP-A1- 2 000 780    EP-A2- 0 853 364**
**WO-A1-2010/037988    WO-A2-98/11641**
**JP-A- 2009 008 580    US-A1- 2012 271 576**

EP 3 126 854 B1

Printed by Jouve, 75001 PARIS (FR)

## Description

Domaine technique:

La présente invention concerne un procédé de mesure de la consommation énergétique des branches d'un réseau électrique, procédé dans lequel on mesure les tensions dudit réseau de manière centralisée au moyen d'un dispositif de mesure des tensions unique raccordé en amont des branches du réseau, on mesure le courant sur au moins une des branches du réseau au moyen d'un dispositif de mesure du courant dédié, on communique via une liaison de communication lesdites mesures de tension audit dispositif de mesure du courant, et on calcule dans ledit dispositif de mesure de courant au moins ladite consommation énergétique de ladite branche du réseau analysée.

La présente invention concerne également un équipement de mesure mettant en oeuvre le procédé de mesure ci-dessus, et comportant un dispositif de mesure des tensions unique raccordé en amont des branches du réseau à analyser pour mesurer les tensions dudit réseau de manière centralisée, au moins un dispositif de mesure du courant dédié raccordé sur une des branches du réseau pour mesurer les courants sur ladite branche du réseau, lesdits dispositifs de mesure étant connectés entre eux par au moins une liaison de communication permettant la communication desdites mesures de tension audit dispositif de mesure du courant lequel comporte au moins une unité de traitement pour calculer ladite consommation énergétique de ladite branche du réseau analysée.

Technique antérieure :

La demande croissante de réductions des consommations électriques liée aux problèmes d'efficacité énergétique entraine la mise en place quasi obligatoire d'une instrumentation très détaillée des réseaux électriques afin de pouvoir identifier les origines des consommations électriques, suivre l'évolution de ces consommations, prendre des mesures pour réduire ces consommations et évaluer l'impact des actions de réduction des consommations. La mesure d'une consommation d'énergie électrique sur une branche d'un réseau électrique impose la mesure simultanée des tensions et des courants circulants dans cette branche. La multiplication des prises de tension présente deux inconvénients majeurs :

- l'encombrement et le prix des protections nécessaires aux prises de mesure de tension, et
- l'encombrement et le prix des circuits de mesure de tension dans les dispositifs de mesure.

Ces deux inconvénients représentent un frein important à la multiplication des équipements d'analyse d'énergie.
Or, lorsqu'on se limite à un tableau de distribution électrique, on constate que la tension est à peu près la même en tous les points de ce tableau. En conséquent, il semble intéressant de mutualiser ou de centraliser la prise de tension en amont pour analyser les consommations de toutes les branches du réseau distribuées par ce tableau électrique.

Même si la précision des mesures de puissance dans une optique d'analyse de répartition des consommations n'a pas besoin d'être très bonne, il est cependant important que les variations de puissance consommée soient correctement évaluées, ce qui implique un faible déphasage entre les mesures de courant et les mesures de tension. Par exemple, si on constate qu'un moteur électrique est surdimensionné et fonctionne avec un facteur de puissance très bas générant une forte consommation énergétique, et qu'on le remplace par un moteur de plus faible puissance fonctionnant avec un facteur de puissance beaucoup plus élevé, une erreur de phase trop importante sur les mesures peut conduire à constater une diminution des consommations beaucoup plus faible que prévue. A titre d'exemple, une erreur de phase de 0.3° représente une erreur de mesure de puissance de l'ordre de 1% pour un facteur de puissance de 0.50. La multiplication des charges électroniques non linéaires induit également la présence de puissances liées aux harmoniques du courant et de la tension. De ce fait, l'analyse précise de ces puissances harmoniques impose une qualité de synchronisation encore supérieure à celle exigée pour la mesure de puissance sur le réseau. Un système d'analyse des consommations d'énergie doit donc présenter une erreur de phase entre courants et tensions la plus faible possible, typiquement de l'ordre de 0.1° à 50Hz, ce qui représente environ 5$\mu$s à 50Hz.

Enfin, la mise en oeuvre d'un tel équipement de mesure doit être la plus simple possible, en particulier au niveau du câblage, ainsi que l'association correcte entre les circuits de mesure des tensions et les circuits de mesure des courants dans le cadre d'un réseau triphasé et de l'intégration de ces mesures dans des unités de supervision existantes.

La solution la plus couramment utilisée pour analyser les consommations de multiples branches d'un réseau électrique consiste à installer des dispositifs de mesure comportant à la fois des circuits de mesure des tensions et des circuits de mesure des courants. Ces dispositifs de mesure sont en général reliés entre eux par une liaison de communication, elle-même reliée à une unité de supervision. L'inconvénient majeur de cette solution est la nécessité de réaliser de multiples connexions destinées à la mesure des tensions sur toutes les branches du réseau, ces connexions devant en plus être protégées par des fusibles pour des raisons de sécurité. Ces fusibles sont souvent presque aussi encombrants que le dispositif de mesure lui-même. Par ailleurs, ces circuits de mesure des tensions occupent une place relativement importante dans le dispositif de mesure du fait des distances d'isolement à respecter entre parties conductrices sous tension dangereuses, à la fois entre les polarités différentes et par rapport aux parties conductrices accessibles à un utilisateur.

La publication US 6,330,516 B1 décrit une solution proposant une prise de tension unique et un nombre relativement important de capteurs de courant. Cette approche répond partiellement aux problèmes posés précédemment, puisqu'une seule connexion de tension est réalisée. Cependant, le dispositif de mesure devient relativement encombrant du fait du grand nombre d'entrées pour les capteurs de courant et pour l'électronique qui y est associée. Par ailleurs, l'électronique de conditionnement et de traitement doit être dimensionnée pour pouvoir traiter le nombre maximum de capteurs de courant prévus pour être raccordés, ce qui réduit l'intérêt économique de cette solution si toutes les voies de mesure ne sont pas utilisées. Par ailleurs, la concentration des multiples câbles de connexion des capteurs de courant en seul point rend le câblage ainsi que sa vérification très compliqués.

La publication EP 0 853 364 A2 décrit un équipement pourvu d'un dispositif de mesure de tension et de multiples dispositifs de mesure de courant reliés entre eux par une liaison de communication. Dans cet équipement, le dispositif de mesure de tension transmet régulièrement les amplitudes et la phase des tensions mesurées, et les dispositifs de mesure de courant calculent la puissance à partir de la relation $P = U \times I \times \cos\Phi$. L'inconvénient de cette méthode est l'absence de prise en compte des harmoniques.

La publication EP 1 010 015 B1 décrit un équipement du même type, sans préciser de manière claire quel type d'information en plus de la tension est transmis aux dispositifs de mesure de courant.

Ces solutions existantes ne sont donc pas satisfaisantes.

Exposé de l'invention :

La présente invention vise à pallier ces inconvénients en proposant une solution économique, adaptée aux besoins réels du réseau électrique à analyser, particulièrement simple à mettre en oeuvre grâce à un câblage très simplifié, permettant une synchronisation des échantillons de tension et de courant mesurés de l'ordre de $1\mu s$, c'est-à-dire garantissant une excellente qualité métrologique malgré la présence éventuelle d'harmoniques.

Dans ce but, l'invention concerne un procédé du genre indiqué en préambule, caractérisé en ce que l'on procède aux mesures des tensions dudit réseau par échantillonnage des tensions à une première fréquence d'échantillonnage, l'on procède aux mesures du courant de la branche du réseau par échantillonnage des courants à une seconde fréquence d'échantillonnage, l'on compare l'écart existant entre les instants d'échantillonnage des tensions et des courants et l'on ajuste au moins une fréquence d'échantillonnage par rapport à l'autre pour ramener l'écart existant entre les instants d'échantillonnage des tensions et des courants vers zéro.

Dans une forme préférée, le dispositif de mesure des tensions transmet les échantillons de tension sur la liaison de communication à un instant d'échantillonnage $T_{v,n}$ en utilisant une trame d'informations de durée D, le dispositif de mesure du courant reçoit ces échantillons de tension et détecte l'instant de fin de réception de ladite trame d'informations $T_{rec,n}$, puis calcule l'instant d'échantillonnage $T_{v,n}$ des échantillons de tension et l'écart $\Delta T_n$ entre l'instant d'échantillonnage des courants $T_{i,n}$ et l'instant d'échantillonnage des tensions $T_{v,n}$ pour ajuster sa propre fréquence d'échantillonnage de manière à ramener cet écart vers 0 en augmentant la fréquence d'échantillonnage si l'écart $\Delta T_n$ est positif et en la diminuant si l'écart $\Delta T_n$ est négatif.

Avantageusement, le dispositif de mesure des tensions transmet les échantillons de tension sur la liaison de communication avec un retard fixe R par rapport à l'instant d'échantillonnage des tensions $T_{v,n}$ en utilisant une trame d'informations de durée connue D. Dans ce cas, le dispositif de mesure de courant calcule l'instant d'échantillonnage des tensions $T_{v,n}$ à partir des données connues D et R selon la formule : $T_{v,n} = T_{rec,n} - D - R$, et calcule l'écart $\Delta T_n$ entre l'instant d'échantillonnage des courants $T_{i,n}$ et l'instant d'échantillonnage des tensions $T_{v,n}$ selon la formule $\Delta T_n = T_{i,n} - Tv,n = Trec,n - D - R$.

On peut utiliser la liaison de communication pour transmettre dudit dispositif de mesure des tensions audit dispositif de mesure du courant des informations additionnelles choisies dans le groupe comprenant le type de réseau monophasé ou triphasé, avec ou sans neutre, la tension nominale du réseau, la fréquence nominale du réseau, la date et l'heure, des tops de synchronisation des mesures de valeurs efficaces et de puissance, des tops de capture d'événements.

Selon le cas, on peut transmettre les échantillons des mesures de tension par paquet de N échantillons. On peut aussi choisir une fréquence d'échantillonnage des mesures de tension fixe ou asservie à la fréquence du réseau électrique analysé.

De préférence, on transmet les échantillons des mesures de tension sous forme numérique sur un câble réseau connecté au dispositif de mesure du courant, ce câble réseau comportant au moins une première paire de fils conducteurs appelée paire de communication unidirectionnelle.

On peut avantageusement utiliser le même câble réseau pour amener une alimentation électrique auxdits dispositifs de mesure sur une deuxième paire de fils conducteurs dédiée appelée paire d'alimentation.

On peut encore utiliser le même câble réseau pour connecter les dispositifs de mesure à une unité de surveillance par une troisième paire de fils conducteurs dédiée appelée paire de communication bidirectionnelle.

Dans une première application, on peut mesurer les tensions du réseau électrique par rapport à un potentiel de référence constitué par la terre dudit réseau. Dans ce cas, on peut injecter un courant de défaut à la terre dans le réseau analysé, on peut mesurer ledit courant de défaut injecté et on peut ainsi déterminer l'impédance de fuite à la terre d'au moins des branches dudit réseau analysé.

Dans une seconde application, le dispositif de mesure du courant peut fournir un signal auxiliaire représentatif de la tension du conducteur sur lequel on mesure le courant, ledit signal de tension auxiliaire étant dans ce cas utilisé pour mettre en correspondance la mesure de tension avec la mesure de courant effectuée sur un même conducteur dudit réseau électrique et pallier automatiquement les erreurs de branchement.

Dans une troisième application, le dispositif de mesure du courant peut également mesurer la tension locale sur ladite branche du réseau pour calculer localement au moins ladite consommation d'énergie et la comparer avec ladite consommation d'énergie calculée à partir des mesures de tension centralisées permettant d'évaluer ainsi les pertes énergétiques dans ledit réseau.

Dans une quatrième application, on peut utiliser au moins un autre dispositif de mesure des tensions connecté à un autre réseau électrique à analyser. Dans ce cas, on transmet à l'un des dispositifs de mesure des tensions, les échantillons des mesures de tension obtenus par l'autre dispositif de mesure des tensions sur ladite liaison de communication, et on compare en amplitude et en phase les deux réseaux électriques analysés pour les connecter ensemble lorsque lesdites différences sont suffisamment faibles.

Lorsque les deux réseaux électriques sont connectés ensemble, l'un quelconque des dispositifs de mesure des tensions prend le contrôle de la liaison de communication et est utilisé pour mesurer les tensions dudit réseau correspondant.

Dans ce but également, l'invention concerne un équipement du genre indiqué en préambule, caractérisé en ce que le dispositif de mesure des tensions comporte des moyens pour effectuer les mesures de tension par échantillonnage des tensions à une première fréquence d'échantillonnage, en ce que le dispositif de mesure du courant comporte des moyens pour effectuer les mesures du courant par échantillonnage des courants à une seconde fréquence d'échantillonnage, des moyens pour comparer l'écart existant entre les instants d'échantillonnage des tensions et des courants, et en ce que lesdits dispositifs de mesure des tensions et du courant comportent des moyens pour ajuster au moins une fréquence d'échantillonnage par rapport à l'autre pour ramener l'écart existant entre les instants d'échantillonnage des tensions et des courants vers zéro.

Dans une forme préférée de l'invention, le dispositif de mesure des tensions comporte au moins un oscillateur ajustable agencé pour définir la fréquence d'échantillonnage des mesures de tension et au moins une unité de traitement agencée pour traiter au moins lesdits échantillons de tension.

Le dispositif de mesure des tensions peut en outre comporter un module de fréquence agencé pour mesurer la fréquence du réseau analysé, l'unité de traitement étant agencée pour traiter également les mesures de fréquence du réseau. Dans ce cas, l'oscillateur ajustable peut être asservi par l'unité de traitement en fonction de la fréquence du réseau.

Dans la forme de réalisation préférée, le dispositif de mesure du courant comporte au moins un oscillateur ajustable agencé pour définir ladite fréquence d'échantillonnage des mesures de courant et au moins une unité de traitement agencée pour calculer au moins l'énergie consommée par ladite branche du réseau à partir des échantillons de tension reçus par la liaison de communication et des échantillons de courant mesurés sur ladite branche.

Le dispositif de mesure du courant peut en outre comporter un module de déphasage agencé pour mesurer l'écart existant entre les instants d'échantillonnage des tensions et les instants d'échantillonnage des courants et pour asservir l'oscillateur ajustable afin d'ajuster la fréquence d'échantillonnage des mesures de courant pour la synchroniser sur la fréquence d'échantillonnage des mesures de tension.

La liaison de communication peut être constituée d'au moins une paire de fils conducteurs, appelée paire de communication unidirectionnelle, prévue dans un câble réseau pour transmettre les échantillons de tension sous forme numérique, ce câble réseau étant agencé pour connecter ledit dispositif de mesure des tensions centralisé audit dispositif de mesure du courant dédié par l'intermédiaire de connecteurs adaptés.

En complément, le câble réseau peut comporter une deuxième paire de fils conducteurs dédiée appelée paire d'alimentation agencée pour amener une alimentation électrique auxdits dispositifs de mesure.

Le câble réseau peut également comporter une troisième paire de fils conducteurs dédiée appelée paire de communication bidirectionnelle agencée pour connecter lesdits dispositifs de mesure à une unité de surveillance.

Dans une première variante de réalisation, l'équipement de mesure peut comporter des moyens pour injecter un courant de défaut à la terre dans le réseau analysé. Dans ce cas, le dispositif de mesure du courant comporte un capteur agencé pour mesurer ledit courant de défaut à la terre et l'unité de traitement est agencée pour déterminer l'impédance de fuite à la terre de ladite branche dudit réseau analysée à partir des échantillons de tension reçus par la paire de communication unidirectionnelle et des échantillons de courant de fuite à la terre mesurés localement.

Dans une seconde variante de réalisation, le dispositif de mesure du courant peut comporter un capteur de tension auxiliaire agencé pour mesurer un signal auxiliaire représentatif de la tension du conducteur sur lequel ledit dispositif mesure le courant, l'unité de traitement comportant alors un module de corrélation agencé pour mettre en correspondance la mesure de tension avec la mesure de courant effectuée sur un même conducteur dudit réseau électrique.

Dans une troisième variante de réalisation, le dispositif de mesure du courant peut comporter en outre un capteur de tension pour mesurer la tension locale sur ladite branche du réseau analysé, l'unité de traitement étant dans ce cas agencée pour calculer localement au moins ladite consommation d'énergie et la comparer avec ladite consommation d'énergie calculée à partir des mesures de tension centralisées pour évaluer les pertes énergétiques dans les câbles dudit réseau.

Dans une quatrième variante de réalisation, l'équipement de mesure peut comporter au moins un autre dispositif de mesure des tensions connecté à un autre réseau électrique à analyser, cet autre dispositif de mesure des tensions étant connecté audit dispositif de mesure des tensions du réseau principal par ladite liaison de communication.

De manière avantageuse, l'équipement de mesure comporte un nombre N de dispositifs de mesure de courant dédiés correspondant au nombre N de branches du réseau électrique à analyser, tous les dispositifs de mesure du courant étant connectés audit dispositif de mesure des tensions centralisé.

Cet équipement de mesure comporte avantageusement au moins un dispositif de terminaison de ligne disposé à la fin de ladite paire de communication unidirectionnelle, et au moins un dispositif de connexion disposé en amont des branches du réseau électrique à analyser et agencé pour faire l'interface électrique entre lesdits dispositifs de mesure d'une part et au moins une alimentation électrique et une unité de supervision d'autre part.

Description sommaire des dessins :

La présente invention et ses avantages apparaîtront mieux dans la description suivante d'un mode de réalisation donné à titre d'exemple non limitatif, en référence aux dessins annexés, dans lesquels:

- la figure 1 représente schématiquement une vue d'ensemble d'un équipement de mesure selon l'invention pour un réseau électrique comportant plusieurs branches,
- la figure 2 est un diagramme montrant la synchronisation de l'échantillonnage des mesures de tension et de courant sur une échelle du temps,
- la figure 3 est une vue schématique montrant les différentes liaisons d'alimentation et de communication entre un dispositif de mesure des tensions et un dispositif de mesure du courant entrant dans l'équipement de mesure de la figure 1,
- la figure 4 est un schéma de principe du dispositif de mesure des tensions et de deux dispositifs de mesure du courant entrant dans l'équipement de mesure de la figure 1,
- la figure 5 est un schéma de principe d'un dispositif de connexion entrant dans l'équipement de mesure de la figure 1,
- les figures 6A et 6B illustrent deux exemples de mise en oeuvre de l'équipement de mesure de la figure 1 respectivement sur un réseau triphasé et sur un réseau monophasé, et
- la figure 7 est un diagramme des signaux de tension du réseau triphasé de la figure 6A et du signal de tension auxiliaire mesuré par un dispositif de mesure du courant pourvu d'un module de corrélation recherchant automatiquement la voie de tension correspondant le mieux à la tension auxiliaire mesurée.

Illustrations de l'invention et meilleure manière de la réaliser :

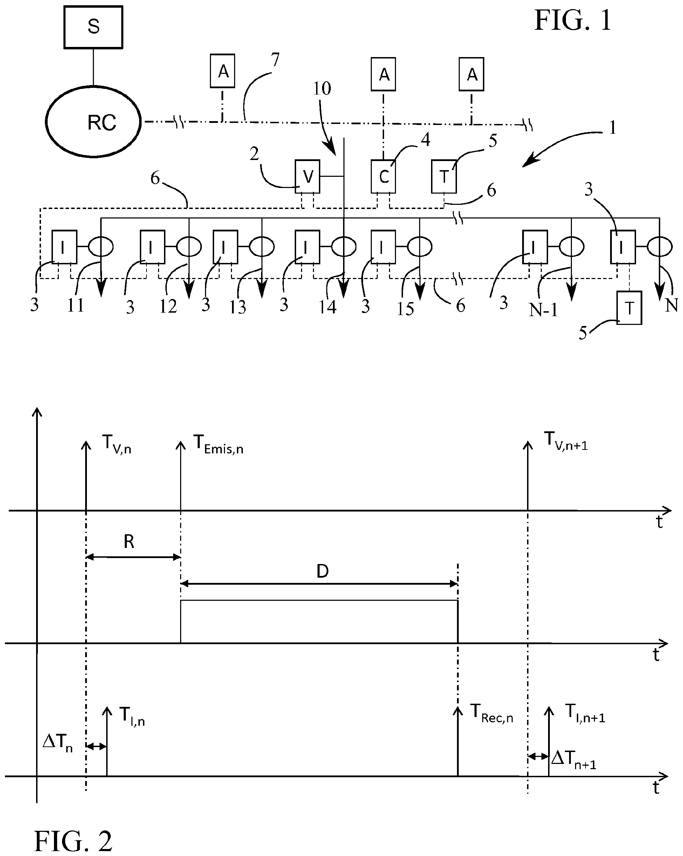

En référence aux figures et plus particulièrement de la figure 1, l'équipement de mesure 1 selon l'invention comporte quatre composants principaux :

- un dispositif de mesure des tensions 2 d'un réseau électrique 10,
- un ou plusieurs dispositifs de mesure de courant 3 des branches 11-N de ce réseau 10, chaque branche alimentant au moins une charge (non représentée),
- un dispositif de connexion 4 assurant la connexion de l'équipement de mesure 1 avec son environnement extérieur, telle que par exemple une alimentation électrique 8, un bus de communication 7, etc., et
- un dispositif de terminaison de ligne 5 permettant de garantir la qualité de la transmission des signaux en assurant la terminaison des lignes de communication.

Cet équipement de mesure 1 peut ou non faire partie d'un système plus complet comportant notamment une unité de surveillance S et un ou plusieurs autres appareils A connectés au bus de communication 7. Ce bus de communication 7 permet de véhiculer des informations sous la forme de signaux numériques selon un protocole de communication défini et normalisé. Il peut ainsi être constitué d'un bus de communication standard de type RS485 et d'un protocole de communication du type JBUS/MODBUS ou similaire, et peut être relié directement à l'unité de surveillance S ou via un réseau de communication RC de type Internet ou similaire. Les autres appareils A connectés doivent être compatibles avec le protocole de communication utilisé. Ils peuvent être constitués, à titre d'exemple non limitatif, d'un compteur d'énergie, d'une centrale de mesure des paramètres du réseau électrique, de modules d'entrée et de sortie analogiques et/ou numériques assurant l'interface avec des capteurs, des automates, des appareils de coupure ou similaires, de capteurs de température, de capteurs de pression, ainsi que tout autre appareil communément raccordé à un bus de terrain, etc.

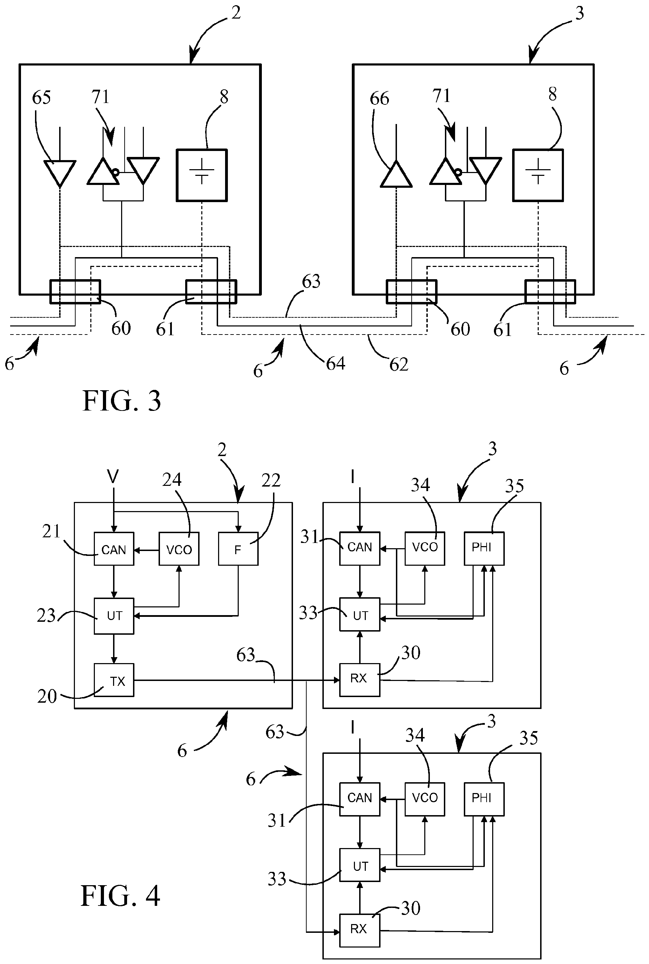

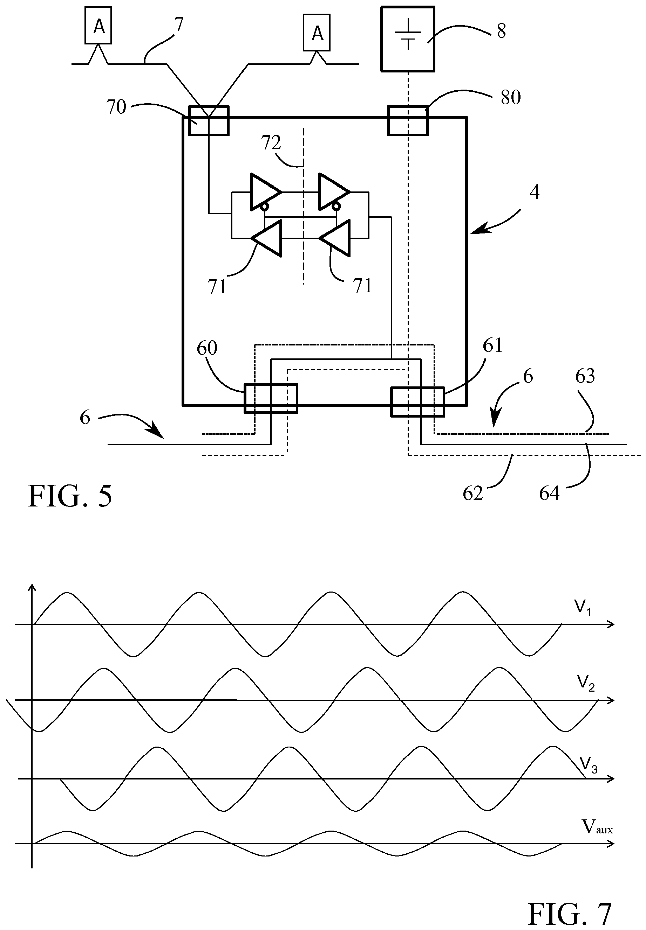

Avantageusement mais non exclusivement, les différents dispositifs 2-5 sont connectés entre eux, en série, par un chaînage de câbles réseau 6. Ces câbles réseau 6 peuvent être constitués d'un câble réseau standard, normalisé, typiquement un câble réseau UTP Catégorie 3, composé de quatre paires torsadées, formées chacune de deux fils conducteurs enroulés en hélice l'un autour de l'autre. Bien entendu, tout autre type de câble réseau peut convenir. Chaque dispositif 2-5 dispose, en conséquence, de deux connecteurs à huit positions et huit contacts, un connecteur d'entrée 60 et un connecteur de sortie 61, conformément aux figures 3 et 5. Ces connecteurs peuvent être des connecteurs standards, normalisés, communément appelés des connecteurs RJ45, permettant une connexion simple, rapide, en série des différents dispositifs entre eux, ce type de connexion étant communément appelée « daisy chain ». Bien entendu, tout autre type de connecteurs compatibles avec le câble réseau peut convenir.

Comme évoqué précédemment tout autre type de câbles réseau 6 peut convenir dans l'hypothèse où le nombre de paires torsadées est au moins égal à deux. En effet, l'intérêt de ces câbles réseau 6 est de pouvoir véhiculer plusieurs types de signaux dans un même câble pour simplifier au maximum le câblage. L'équipement de mesure 1 nécessite par conséquent au moins :

- une première paire torsadée pour assurer l'alimentation électrique des dispositifs 2-5 à partir du réseau, en basse tension par exemple 24V, appelée par la suite « paire d'alimentation 62 », et
- une seconde paire torsadée pour assurer la communication unidirectionnelle des signaux de tension du dispositif de mesure des tensions 2 vers les dispositifs de mesure du courant 3, appelée par la suite « paire de communication unidirectionnelle 63 ».

Il peut être complété, comme représenté sur les figures, par une troisième paire torsadée pour assurer la communication bidirectionnelle entre les dispositifs 2-5 de l'équipement de mesure 1 et l'unité de surveillance S, appelée par la suite « paire de communication bidirectionnelle 64 ».

Dans le cas avantageux décrit précédemment de l'utilisation d'un câble réseau 6 à quatre paires torsadées, la quatrième paire torsadée (non représentée sur les figures) peut être utilisée en parallèle de la paire d'alimentation 62 pour doubler la puissance de l'alimentation électrique.

Pour permettre aux différents dispositifs 2-5 de communiquer entre eux via cette connectique réseau, chacun est équipé de connecteurs 60, 61 de type RJ45 adaptés aux mêmes connecteurs prévus aux extrémités des câbles réseau 6. Ils comportent en outre des moyens de transmission des données sous la forme d'émetteurs 65 et de récepteurs 66 associés à la paire de communication unidirectionnelle 63, et des émetteurs/récepteurs 71 associés avec la paire de communication bidirectionnelle 64. La figure 3 représente un dispositif de mesure des tensions 2 et un dispositif de mesure du courant 3 connectés l'un à l'autre par un câble réseau 6 via les connecteurs 60, 61. Les câbles réseau 6 représentés dans les figures sont illustrés avec trois paires torsadées 62, 63, 64. Le dispositif de mesure des tensions 2 comporte une alimentation électrique 8 en provenance de la paire d'alimentation 62, un émetteur 65 connecté à la paire de communication unidirectionnelle 63 pour transmettre les signaux des tensions mesurées aux dispositifs de mesure du courant 3, et un émetteur/récepteur 71 connecté à la paire de communication bidirectionnelle 64. Et le dispositif de mesure du courant 3 comporte une alimentation électrique 8 en provenance de la paire d'alimentation 62, un récepteur 66 connecté à la paire de communication unidirectionnelle 63 pour recevoir les signaux des tensions mesurées du dispositif de mesure des tensions 2, et un émetteur/récepteur 71 connecté à la paire de communication bidirectionnelle 64. La figure 5 représente le dispositif de connexion 4 pourvu d'un connecteur 80 connecté à une alimentation électrique 8 du réseau pour alimenter la paire d'alimentation 62, d'un connecteur 70 connecté au bus de communication 7 pour y raccorder la paire de communication bidirectionnelle 64 par l'intermédiaire de deux émetteurs/récepteurs 71 séparés par une isolation galvanique 72. Le dispositif de terminaison de ligne 5 n'est pas représenté en tant que tel puisqu'il est constitué d'un élément connu et standard formé d'une combinaison de résistances connectées en permanence aux paires de communication 63 et 64. Ce dispositif de terminaison de ligne 5 a pour fonction d'adapter l'impédance de chacune des deux paires de communication 63 et 64 afin d'éviter les réflexions sur les câbles réseaux 6 et d'assurer ainsi une bonne qualité de transmission du signal.

La figure 4 représente le principe de fonctionnement des dispositifs de mesure 2 et 3 sous la forme de schémas blocs.

Le dispositif de mesure des tensions 2 comporte notamment :

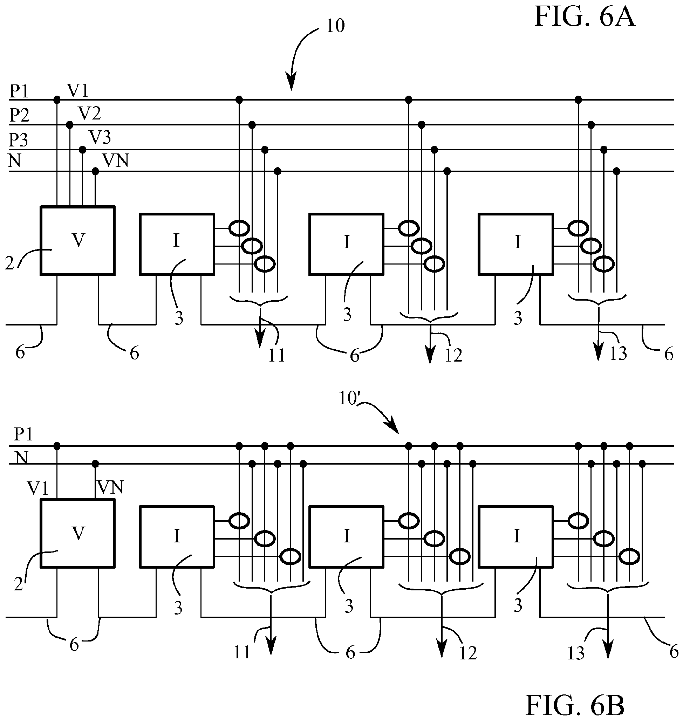

- un convertisseur analogique/numérique 21 qui transforme les valeurs analogiques des tensions mesurées par des capteurs de tension, représentés par des points sur les figures 6A et 6B, en signaux numériques pour les communiquer à une unité de traitement 23,
- un module de mesure de fréquence 22 qui mesure la fréquence des tensions mesurées pour les communiquer à l'unité de traitement 23,
- l'unité de traitement 23 qui traite les signaux des tensions mesurées et de la fréquence mesurée pour communiquer des signaux traités sur la paire de communication unidirectionnelle 63 d'un câble réseau 6 par un émetteur 20, et
- un oscillateur ajustable 24 qui fournit la fréquence d'échantillonnage au convertisseur analogique/numérique 21 et dont la fréquence d'échantillonnage est ajustée par l'unité de traitement 23 en fonction de la mesure de la fréquence réseau fournie par le module de mesure de fréquence 22.

Les dispositifs de mesure du courant 3 comportent chacun notamment :

- un convertisseur analogique/numérique 31 qui transforme les valeurs analogiques des courants mesurés par des capteurs de courant, représentés par des tores sur les figures 6A et 6B, en signaux numériques pour les communiquer à une unité de traitement 33,
- l'unité de traitement 33 qui traite les signaux des courants mesurés avec les signaux des tensions et de la fréquence reçus via la paire de communication unidirectionnelle 63 du câble réseau 6 par un récepteur 30, pour calculer des valeurs de mesure exploitables par un opérateur et/ou une unité de surveillance S, telles que des valeurs de puissance, d'énergie consommée, de facteur de puissance, une analyse harmonique des courants, etc.
- un oscillateur ajustable 34 qui fournit la fréquence d'échantillonnage au convertisseur analogique/numérique 31 et dont la fréquence d'échantillonnage est ajustée par l'unité de traitement 33 en fonction de la mesure de déphasage fournie par une unité de mesure du déphasage 35, et
- l'unité de mesure du déphasage 35 qui reçoit des données de l'oscillateur 34 et du récepteur 30 pour communiquer avec l'unité de traitement 33 et modifier le cas échéant la fréquence d'échantillonnage des mesures du courant.

En référence plus particulièrement aux figures 1, 6A et 6B, le dispositif de mesure des tensions 2 est installé en amont des branches 11, 12, 13, N du réseau électrique 10 qui peut être polyphasé (figure 6A) ou monophasé (figure 6B). Il effectue la mesure des tensions V1, V2, V3, VN sur les conducteurs de phase P1, P2, P3, et sur le conducteur de neutre N s'il existe, du réseau électrique 10, par tout capteur de tension existant permettant de délivrer un signal représentatif de la tension mesurée, ce capteur de tension pouvant être avec ou sans contact, tel que des prises de tension directes, des capteurs capacitifs, des capteurs de champ électrique, ou similaire.

Les dispositifs de mesure de courant 3 sont installés chacun sur une des branches 11, 12, 13, N du réseau électrique 10 et effectuent la mesure du courant I sur chaque conducteur de phase P1, P2, P3 du réseau électrique 10. La mesure des courants peut être effectuée par tout capteur de courant existant permettant de délivrer un signal représentatif du courant mesuré, tel que par exemple des transformateurs de courant comme illustrés aux figures 6A et 6B, des boucles de Rogowski, des capteurs à base de mesure champ magnétique telle que l'effet Hall ou des magnétomètres de type fluxgate, ou similaire.

Les mesures des tensions et des courants s'effectuent périodiquement par échantillonnage pour transmettre des trames d'informations exploitables numériquement sur la paire de communication unidirectionnelle 63 des câbles réseau 6. La figure 2 permet d'illustrer ce procédé de mesure ayant pour objectif d'atteindre un degré de synchronisation entre les échantillons de tension et les échantillons de courant très élevé par rapport aux systèmes connus. La ligne supérieure du diagramme représente l'activité du dispositif de mesure des tensions 2, la ligne inférieure du diagramme représente l'activité des dispositifs de mesure du courant 3 et la ligne médiane du diagramme représente les échantillons de tension véhiculés sur la paire de communication unidirectionnelle 63.

La fréquence d'échantillonnage des mesures de tension est déterminée par l'oscillateur 24 et est avantageusement mais non nécessairement asservie à la fréquence du réseau électrique 10 à analyser, par exemple égale à 50Hz. Cet asservissement est particulièrement avantageux s'il faut effectuer simultanément une analyse harmonique des tensions et des courants mesurés, d'où l'intérêt du module de fréquence 22 qui communique la mesure de la fréquence du réseau à l'unité de traitement 23, lui permettant d'ajuster la fréquence d'échantillonnage en agissant sur l'oscillateur 24 .

Le dispositif de mesure des tensions 2 échantillonnent les tensions à l'instant Tv,n et émet, avec un retard d'émission fixe R par rapport à l'instant d'échantillonnage des tensions Tv,n, une trame d'informations d'une durée D sur la paire de communication unidirectionnelle 63 des câbles réseaux 6 reliant le dispositif de mesure des tensions 2 aux dispositifs de mesure de courant 3 via l'émetteur 20 et les récepteurs 30.

Simultanément, les dispositifs de mesure du courant 3 échantillonnent les courants à l'instant $T_{I,n}$ et reçoivent tous en même temps, au retard près de propagation dans les câbles réseaux 6, la trame d'informations du dispositif de mesure des tensions 2. Ils disposent également de moyens pour déterminer l'instant de réception $T_{rec,n}$ de la trame d'informations des échantillons de tension dans l'unité de traitement 33.

Préférentiellement, mais non exclusivement, l'instant de réception $T_{rec,n}$ de la trame de données des échantillons de tension correspond au dernier changement d'état de la trame d'informations, c'est-à-dire la fin de sa transmission. Connaissant la durée D de la trame d'informations qui est généralement une donnée connue par les dispositifs de mesure de courant 3, les dispositifs de mesure de courant 3 calculent l'écart $\Delta T_n$ entre l'instant d'échantillonnage des tensions $T_{v,n}$ et l'instant d'échantillonnage $T_{i,n}$ correspondant pour les courants. Cet écart $\Delta T_n$ est évalué par :

$$\Delta T_n = T_{I,n} - T_{v,n} = T_{I,n} - T_{rec,n} + R + D$$

Si l'écart $\Delta T_n$ est positif, comme illustré sur la figure 2, cela signifie que l'échantillonnage des courants est en retard par rapport à l'échantillonnage de tensions et qu'il faut donc accélérer la fréquence d'échantillonnage des courants pour diminuer ce retard. A l'inverse, si l'écart $\Delta T_n$ est négatif, il faut diminuer la fréquence d'échantillonnage des courants. De manière préférentielle, l'ajustement de la fréquence d'échantillonnage est calculée au moyen d'un correcteur de type proportionnel/intégral intégré à l'unité de traitement 33 en fonction des données fournies par le module de déphasage 35. L'unité de traitement 33 commande en conséquence l'oscillateur ajustable 34 qui va osciller à la fréquence d'échantillonnage imposée par l'unité de traitement 33.

Pour s'assurer que la durée D entre le début et la fin de la trame d'informations des échantillons de tension est fixe, la trame d'informations peut se terminer toujours par un bit de fin de message. Cette méthode est particulièrement adaptée à l'utilisation de microcontrôleurs modernes incluant des récepteurs série asynchrones rapides, généralement dénommés UART, des systèmes de transferts directs de données vers la mémoire, généralement dénommés DMA, et des unités de mesure de durée. On peut également connaitre la durée D de la trame d'informations en incluant cette information dans la trame elle-même, autorisant ainsi des trames de durée variable. Toutefois, dans ce cas, les traitements des informations dans les unités de traitement 33 sont alors plus complexes et peuvent conduire à utiliser des microcontrôleurs plus puissants que nécessaire.

Chaque dispositif de mesure de courant 3 effectue alors, à partir des échantillons de tensions reçus du dispositif de mesure des tensions 2 par la paire de communication unidirectionnelle 63 et des échantillons de courant obtenus localement à des instants presque identiques, les mêmes calculs de puissance, d'énergie, etc. que si les échantillons de courant et de tension étaient tous obtenus de manière synchrone localement par un dispositif de mesure combiné classique. Ainsi, du point de vue d'une unité de supervision rien ne distingue l'équipement de mesure 1 d'un dispositif de mesure combiné classique mesurant directement les tensions et les courants sur chaque phase du réseau.

Les intérêts d'une telle architecture sont multiples :

- la puissance de calcul nécessaire est répartie en fonction du nombre réel de circuits de courant à traiter,
- les dispositifs de mesure de courant 3 peuvent être positionnés au plus près de la charge à analyser, réduisant ainsi les longueurs de câblage entre le capteur et le dispositif de mesure, ce qui assure une meilleure immunité contre les perturbations électromagnétiques, et
- la réalisation et le contrôle du câblage sont grandement simplifiés.

La fréquence d'échantillonnage est bien entendu adaptée à la bande passante de l'analyse harmonique, celle-ci étant généralement de l'ordre de 2 à 3 kHz.

A titre indicatif, la plage de fréquence d'échantillonnage peut être comprise entre 1kHz et 20kHz, avec une précision de régulation $\Delta T_n$ de l'ordre de 1μs. Une fréquence d'échantillonnage de l'ordre 5kHz à 10kHz est raisonnable. Dans des applications plus basiques, on peut envisager une fréquence d'échantillonnage de l'ordre de 2kHz, permettant d'inclure les harmoniques jusqu'à environ 750Hz.

Pour conserver une bonne précision de mesure, il faut transmettre les échantillons de tension avec une résolution suffisante. Afin de simplifier les traitements, on choisit en général un nombre entier d'octets pour la représentation des données, ce qui conduit à représenter de manière préférentielle les tensions sur 8 ou 16 bits. Mais on peut également envisager des tailles de représentation intermédiaires pour optimiser l'utilisation de la bande passante des paires de communication unidirectionnelle 63.

En fonction des besoins de l'application considérée, on peut également choisir de transmettre les valeurs des tensions entre phase et neutre, que ce neutre soit mesuré ou virtuel, ou les tensions des phases et du neutre par rapport à un potentiel de référence du réseau électrique, ce potentiel de référence étant en général mais non nécessairement la terre de l'installation.

Dans la suite, nous nous intéresserons à une application permettant une analyse harmonique jusqu'à environ 3kHz et une représentation des données de tension sur 16 bits, avec une transmission des tensions par rapport à un potentiel de référence. Toutefois, d'autres choix peuvent être effectués en fonction de l'application considérée.

La bande passante nécessaire à la transmission des échantillons de tension d'un réseau 10 triphasé avec neutre (figure 6A) par rapport au potentiel de référence, soit quatre valeurs de tension par instant d'échantillonnage, avec une représentation sur 16 bits, et une fréquence d'échantillonnage de 10kHz, compatible avec une bande passante de 3kHz, représente un volume brut de données de l'ordre de 640 kbit/s. Pour assurer une certaine fiabilité dans la transmission, il est d'usage de rajouter des informations de contrôle, par exemple un numéro de séquence sur un octet et une somme de contrôle sur un octet également, ce qui conduit à un débit brut de l'ordre de 800 kbits/s. Le fonctionnement des différents dispositifs 2-5 étant asynchrone, on privilégie l'utilisation d'une liaison de type asynchrone, caractérisée par la présence d'au moins un bit de démarrage et un bit d'arrêt sur chaque octet, ce qui porte le débit de la liaison à environ 1 Mbits/s. Ce débit est aujourd'hui aisément accessible à cout réduit en utilisant des circuits intégrés spécialisés conformes à la norme RS485 et des microcontrôleurs performants à faible cout capables de traiter de manière efficace des débits de cette nature, tout en autorisant une longueur totale de la paire de communication unidirectionnelle 63 des câbles réseau 6 supérieure à 100m. En fonction des applications, il est cependant envisageable de réduire ce débit pour augmenter la distance autorisée pour la paire de communication unidirectionnelle 63, en réduisant la taille des échantillons de tension, par exemple de 16 bits à 8 bits, ou en réduisant la fréquence d'échantillonnage, ou encore en combinant ces deux solutions. Pour limiter un peu la bande passante ou réduire la charge en temps réel liée à la réception des échantillons de tension, on peut également transmettre les échantillons par paquets de N instants d'échantillonnage, N valant de 1 à quelques dizaines. Cependant, plus la valeur de N est élevée et plus le système sera lent à réagir aux changements de fréquence d'échantillonnage.

Dans un tel équipement de mesure 1, un certain nombre d'informations additionnelles liées à la configuration du réseau et de l'équipement ont besoin d'être connues de tous les dispositifs 2-5 connectés, par exemple et de manière non exhaustive, la tension nominale du réseau 10, la fréquence nominale du réseau 10, le type de raccordement du réseau : avec ou sans neutre, le type de réseau : monophasé ou triphasé, etc. Ces informations additionnelles sont avantageusement transmises sur la même paire de communication unidirectionnelle 63 que les échantillons de tension. Par ailleurs, il est intéressant de pouvoir synchroniser les échantillons des mesures de tension et de courant pour faciliter leur analyse. Ces informations de synchronisation, appelés des tops de synchronisation, sont également avantageusement transmises sur cette même paire de communication unidirectionnelle 63. Il peut s'agir de tops de synchronisation des mesures de valeurs efficaces et de puissance, des tops de capture d'événements. Par événement, on entend des formes d'onde qui peuvent être soit une succession d'échantillons des valeurs de courant ou une succession de valeurs efficaces de courant, de sorte que les dispositifs de mesure du courant 3 effectuent tous les mesures de valeurs efficaces et de puissance sur les mêmes intervalles de temps et capturent tous les formes d'ondes sur le même intervalle de temps. Enfin, si le dispositif de mesure des tensions 2 dispose d'une horloge, la date et l'heure sont également avantageusement transmises sur cette même paire de communication unidirectionnelle 63.

Compte tenu du débit relativement élevé pour la transmission des échantillons de tension sur la paire de communication unidirectionnelle 63 et des longueurs de câblage envisagées (quelques dizaines de mètres), il est indispensable de maîtriser la topologie de ce câblage, qui doit présenter une forme de type bus, avec des bretelles de longueur la plus faible possible. C'est la raison pour laquelle l'invention privilégie un chaînage simple des dispositifs 2-5 entre eux par des câbles réseau 6 et des connecteurs 60, 61 adaptés comme expliqué plus haut.

Toutefois, dans une première variante de réalisation, on peut regrouper seulement l'alimentation électrique et la communication unidirectionnelle rapide dédiée à la transmission des échantillons de tension dans un même câble réseau 6. La liaison de communication bidirectionnelle standardisée utilise dans ce cas un câblage séparé. Cette approche est intéressante si les caractéristiques électriques exigées par la liaison de communication bidirectionnelle diffèrent trop de celles requises pour la liaison de communication unidirectionnelle dédiée aux échantillons de tension. Dans ce cas, la liaison de communication bidirectionnelle est isolée galvaniquement de l'alimentation électrique et de la liaison de communication unidirectionnelle des échantillons de tension dans chaque dispositif de mesure du courant 3. La tension d'alimentation sera choisie suffisamment faible pour permettre la réalisation d'alimentations non isolées, compactes et suffisamment élevées pour permettre de véhiculer une puissance raisonnable sur des câbles réseaux 6, tout en permettant une distance entre le point de connexion de l'alimentation et les dispositifs 2-5 de l'ordre de 100m. Une tension nominale d'alimentation de 24V constitue un bon compromis, mais toute tension compatible avec les critères précédents est envisageable.

Dans une seconde variante de réalisation, on simplifie au maximum le câblage en combinant dans un même câble réseau 6 toutes les fonctions reliant les dispositifs 2-5 entre eux, à savoir l'alimentation électrique en basse tension, la liaison de communication bidirectionnelle standardisée et la liaison de communication unidirectionnelle dédiée à la transmission des échantillons de tension. Trois paires de fils conducteurs 62, 63, 64 sont alors nécessaires. Mais comme les câbles réseaux 6 les plus répandus de type UTP comportent quatre paires de fils conducteurs, cette dernière configuration est retenue préférentiellement comme exposé précédemment. Dans ce cas, l'alimentation électrique peut être véhiculée sur deux paires de fils conducteurs, ce qui permet de doubler la puissance transportable. L'isolation galvanique entre l'alimentation électrique et la liaison de communication bidirectionnelle n'est alors plus nécessaire dans chaque dispositif 2-5 de l'équipement 1. Cette isolation galvanique 72 est uniquement nécessaire en un seul point, à savoir dans le dispositif de connexion 4 qui assure l'interfaçage électrique entre l'équipement de mesure 1 et l'unité de supervision S. De cette manière, l'équipement de mesure 1 s'insère sans problème dans un système de supervision existant.

Possibilités d'application industrielle :

Le choix de la transmission des mesures de tension entre phases P1, P2, P3 et neutre N ou entre phases P1, P2, P3, le neutre servant de potentiel de référence, dépend de l'application considérée. La transmission des mesures de tension par rapport à un potentiel de référence permet toujours par différence de retrouver toutes les tensions utiles, mais occupe légèrement plus de bande passante. Une application en particulier tire un avantage de la transmission des mesures de tension par rapport à un potentiel de référence, en l'occurrence la terre du réseau électrique. Il s'agit de la recherche d'un défaut d'isolement en régime de neutre isolé. Dans ce type d'application, un dispositif additionnel (non représenté) permet d'injecter dans le réseau 10 un courant de défaut à la terre à une fréquence très inférieure à la fréquence du réseau appelé courant de localisation. Ce dispositif additionnel peut être à titre d'exemple un générateur de tension avec limitation de courant. On peut également créer volontairement un défaut entre le réseau et la terre pour forcer la circulation d'un courant de défaut. Il existe ainsi différentes techniques pour injecter ou créer un courant de défaut à la terre qui aura tendance à se répartir entre toutes les branches du réseau en fonction des impédances de défaut respectives de chaque branche.

Si les dispositifs de mesure de courant 3 sont conçus pour recevoir les signaux provenant d'un capteur de courant différentiel à la terre, appelé en général tore de localisation, lesdits dispositifs de mesure de courant 3 peuvent, dans ce cas, déterminer l'impédance de fuite à la terre à partir de la mesure de la tension sur l'un quelconque des conducteurs de phase P1, P2, P3 actifs par rapport à la terre, et du courant de fuite à la terre. Dans cette application particulière, il est particulièrement intéressant d'asservir la fréquence d'échantillonnage à la fréquence du réseau mesuré. En effet, l'utilisation de simples filtres à moyenne mobile permet d'éliminer totalement les signaux à la fréquence du réseau et des multiples de cette fréquence qui sont en général de grande amplitude par rapport aux signaux très basse fréquence utilisés pour la détermination de l'impédance de fuite à la terre.

Un autre avantage de la transmission des mesures de tension par rapport à un potentiel de référence réside dans la possibilité de détecter automatiquement sur quelle phase P1, P2, P3 du réseau 10 est raccordé le capteur de courant d'un dispositif de mesure du courant 3, et ce même en l'absence de tout courant de charge. Ceci est possible à condition que le dispositif de mesure du courant 3 fournisse un signal de tension auxiliaire reproduisant fidèlement la forme de la tension du conducteur de phase surveillé. Pour cette fonction de détection automatique, le signal de tension auxiliaire Vaux ne doit pas dépasser un déphasage maximum de l'ordre de quelques degrés par rapport à la fréquence du réseau, tandis que son amplitude n'a pas d'importance. Ce signal de tension auxiliaire Vaux peut être obtenu par un capteur de tension sans contact (non représenté), particulièrement imprécis en amplitude, comme un couplage capacitif ou une mesure de champ électrique. Dans ces conditions, le dispositif de mesure de courant 3, équipé d'un tel capteur de tension, comporte un module de corrélation (non représenté) permettant de détecter automatiquement quelle est la voie de tension qui correspond au capteur de courant en recherchant laquelle des tensions nominales V1, V2, V3 connectées à l'unité de traitement présente le maximum de corrélation avec le signal de tension auxiliaire Vaux. Le diagramme de la figure 7 montre à titre d'exemple la corrélation qui existe entre le signal de tension auxiliaire Vaux obtenu par un capteur de tension intégré dans le dispositif de mesure de courant 3 et la voie de tension V1 correspondant à la phase P1 du réseau électrique 10 sur laquelle le capteur de courant est installé. De la même manière, cette méthode de corrélation s'effectue sur les autres phases P2 et P3.

L'équipement de mesure 1 selon l'invention peut également avoir pour fonction d'évaluer les pertes énergétiques des câbles du réseau. Dans ce cas, les dispositifs de mesure du courant 3 comportent un capteur de tension (non représenté) additionnel pour mesurer la tension locale effective sur les branches du réseau analysé, telle qu'une prise de tension directe. L'unité de traitement 33 peut calculer localement la consommation d'énergie et la comparer avec la consommation d'énergie calculée à partir des mesures de tension centralisées, ceci afin d'évaluer les pertes énergétiques dans les câbles dudit réseau.

Encore une autre application de l'équipement de mesure 1 selon l'invention concerne le cas d'un réseau électrique de secours, tel que par exemple un groupe électrogène, prévu pour remplacer le réseau électrique principal en cas de défaillance. Dans ce cas, l'équipement de mesure 1 est complété par un autre dispositif de mesure des tensions 2 qui est raccordé au réseau de secours (non représenté) et connecté par le câble réseau 6 au dispositif de mesure des tensions 2 du réseau principal pour transmettre, à cet autre dispositif de mesure des tensions 2, les échantillons des mesures de tension obtenus par le premier dispositif de mesure des tensions 2 ou inversement. Les unités de traitement 23 permettent de comparer en amplitude et en phase les deux réseaux dans l'objectif de les raccorder les deux réseaux ensemble lorsque les différences sont suffisamment faibles permettant de passer de l'un à l'autre sans interruption. Dans cette configuration, le dispositif de mesure des tensions dédié au réseau de secours peut devenir maître et fournir aux dispositifs de mesure du courant 3 les échantillons de tension nécessaires.

Il ressort clairement de cette description que l'invention permet d'atteindre les buts fixés, à savoir un équipement de mesure 1 de la consommation des branches d'un réseau électrique 10 particulièrement simple à mettre en oeuvre, capable de s'intégrer dans un système de supervision existant, configuré pour atteindre des précisions de mesure très élevées et pour offrir une flexibilité d'utilisation en fonction des applications considérées.

La présente invention n'est pas limitée à l'exemple de réalisation décrit mais s'étend à toute modification et variante évidentes pour un homme du métier tout en restant dans l'étendue de la protection définie dans les revendications annexées.

**Revendications**

1. Procédé de mesure de la consommation énergétique des branches (11, 12, 13,N) d'un réseau électrique (10), procédé dans lequel on mesure les tensions dudit réseau de manière centralisée au moyen d'un dispositif de mesure des tensions (2) unique raccordé en amont des branches du réseau, on mesure le courant sur au moins une des branches du réseau au moyen d'un dispositif de mesure du courant (3) dédié, on communique via une liaison de communication lesdites mesures de tension audit dispositif de mesure du courant (3), et on calcule dans ledit dispositif de mesure de courant (3) au moins ladite consommation énergétique de ladite branche du réseau analysée, **caractérisé en ce que** l'on procède aux mesures des tensions dudit réseau au moyen dudit dispositif de mesure des tensions (2) unique par échantillonnage des tensions à un instant ($T_{v,n}$) à une première fréquence d'échantillonnage, l'on transmet les échantillons de tension audit dispositif de mesure du courant (3) via la liaison de communication à l'instant d'échantillonnage des tensions ($T_{v,n}$), l'on procède aux mesures du courant de la branche du réseau au moyen dudit dispositif de mesure du courant (3) dédié par échantillonnage des courants à un instant ($T_{i,n}$) à une seconde fréquence d'échantillonnage, l'on compare l'écart existant entre l'instant d'échantillonnage des tensions ($T_{v,n}$) et l'instant d'échantillonnage des courants ($T_{i,n}$) étant donné que lesdits dispositifs de mesure des tensions (2) et du courant (3) fonctionnent de manière asynchrone, et l'on ajuste au moins une fréquence d'échantillonnage par rapport à l'autre pour ramener l'écart existant entre l'instant d'échantillonnage des tensions ($T_{v,n}$) et l'instant d'échantillonnage des courants ($T_{i,n}$) vers zéro.

2. Procédé de mesure selon la revendication 1, **caractérisé en ce que** ledit dispositif de mesure des tensions (2) transmet les échantillons de tension sur la liaison de communication à l'instant d'échantillonnage des tensions ($T_{v,n}$) en utilisant une trame d'informations de durée (D), **en ce que** le dispositif de mesure du courant (3) reçoit ces échantillons de tension et détecte l'instant de fin de réception de ladite trame d'informations ($T_{rec,n}$), **en ce que** le dispositif de mesure du courant (3) calcule l'instant d'échantillonnage des tensions ($T_{v,n}$), **en ce que** le dispositif de mesure de courant (3) calcule l'écart ($\Delta T_n$) entre l'instant d'échantillonnage des courants ($T_{i,n}$) et l'instant d'échantillonnage des tensions ($T_{v,n}$), et **en ce que** le dispositif de mesure de courant (3) ajuste sa propre fréquence d'échantillonnage de manière à ramener cet écart vers zéro en augmentant la fréquence d'échantillonnage si l'écart ($\Delta T_n$) est positif et en la diminuant si l'écart ($\Delta T_n$) est négatif.

3. Procédé de mesure selon la revendication 2, **caractérisé en ce que** ledit dispositif de mesure des tensions (2) transmet les échantillons de tension sur la liaison de communication avec un retard fixe (R) par rapport à l'instant d'échantillonnage des tensions ($T_{v,n}$) en utilisant une trame d'informations de durée connue (D), **en ce que** le dispositif de mesure de courant (3) calcule l'instant d'échantillonnage des tensions ($T_{v,n}$) à partir des données connues (D) et (R) selon la formule : $T_{v,n}=T_{rec,n}-D-R$, et **en ce que** le dispositif de mesure de courant (3) calcule l'écart ($\Delta T_n$) entre l'instant d'échantillonnage des courants ($T_{i,n}$) et l'instant d'échantillonnage des tensions ($T_{v,n}$) selon la formule $\Delta T_n = T_{i,n} - T_{v,n} = T_{i,n} - (T_{rec,n}+D+R)$.

4. Procédé selon la revendication 1, **caractérisé en ce qu'**on utilise ladite liaison de communication pour transmettre dudit dispositif de mesure des tensions (2) audit dispositif de mesure du courant (3) des informations additionnelles choisies dans le groupe comprenant le type de réseau monophasé ou triphasé, avec ou sans neutre, la tension nominale du réseau, la fréquence nominale du réseau, la date et l'heure, des tops de synchronisation des mesures de valeurs efficaces et de puissance, des tops de capture d'événements.

5. Procédé selon la revendication 1, **caractérisé en ce qu'**on transmet lesdits échantillons des mesures de tension par paquet de N échantillons.

6. Procédé selon la revendication 1, **caractérisé en ce qu'**on choisit une fréquence d'échantillonnage des mesures de tension fixe.

7. Procédé selon la revendication 1, **caractérisé en ce qu'**on asservit la fréquence d'échantillonnage des mesures de tension à la fréquence du réseau électrique (10) analysé.

8. Procédé selon l'une quelconque des revendications précédentes, **caractérisé en ce qu'**on transmet les échantillons des mesures de tension sous forme numérique sur un câble réseau (6) connecté audit dispositif de mesure du courant (3), ce câble réseau (6) comportant au moins une première paire de fils conducteurs appelée paire de communication unidirectionnelle (63).

9. Procédé selon la revendication 8, **caractérisé en ce qu'**on utilise le même câble réseau (6) pour amener une alimentation électrique auxdits dispositifs de mesure (2, 3) sur une deuxième paire de fils conducteurs dédiée appelée paire d'alimentation (62).

10. Procédé selon l'une des revendications 8 ou 9, **caractérisé en ce qu'**on utilise le même câble réseau (6) pour connecter lesdits dispositifs de mesure (2, 3) à une unité de surveillance (S) par une troisième paire de fils conducteurs dédiée appelée paire de communication bidirectionnelle (64).

**11.** Procédé selon la revendication 1, **caractérisé en ce qu'**on mesure les tensions dudit réseau électrique (10) par rapport à un potentiel de référence constitué par la terre dudit réseau, **en ce qu'**on injecte un courant de défaut à la terre dans le réseau analysé, **en ce qu'**on mesure ledit courant de défaut injecté et **en ce qu'**on détermine l'impédance de fuite à la terre d'au moins des branches dudit réseau analysé.

**12.** Procédé selon la revendication 1, **caractérisé en ce que** ledit dispositif de mesure du courant (3) fournit un signal auxiliaire représentatif de la tension du conducteur sur lequel on mesure le courant, ledit signal de tension auxiliaire étant utilisé pour mettre en correspondance la mesure de tension avec la mesure de courant effectuée sur un même conducteur dudit réseau électrique (10) et pallier automatiquement les erreurs de branchement.

**13.** Procédé selon la revendication 1, **caractérisé en ce que** ledit dispositif de mesure du courant (3) mesure également la tension locale sur ladite branche du réseau pour calculer localement au moins ladite consommation d'énergie et la comparer avec ladite consommation d'énergie calculée à partir des mesures de tension centralisées pour évaluer les pertes énergétiques dans ledit réseau.

**14.** Procédé selon l'une quelconque des revendications précédentes, **caractérisé en ce qu'**on utilise au moins un autre dispositif de mesure des tensions (2) connecté à un autre réseau électrique à analyser, **en ce qu'**on transmet à l'un des dispositifs de mesure des tensions (2), les échantillons des mesures de tension obtenus par l'autre dispositif de mesure des tensions (2), sur ladite liaison de communication et **en ce qu'**on compare en amplitude et en phase les deux réseaux électriques analysés pour les connecter ensemble lorsque lesdites différences sont suffisamment faibles.

**15.** Procédé selon la revendication 14, **caractérisé en ce que**, lorsque les deux réseaux électriques (10) sont connectés ensemble, l'un quelconque des dispositifs de mesure des tensions (2) prend le contrôle de la liaison de communication et est utilisé pour mesurer les tensions dudit réseau correspondant.

**16.** Equipement de mesure de la consommation énergétique des branches (11, 12, 13,N) d'un réseau électrique (10) mettant en oeuvre le procédé de mesure selon l'une quelconque des revendications précédentes, équipement comportant un dispositif de mesure des tensions (2) unique raccordé en amont des branches du réseau à analyser pour mesurer les tensions dudit réseau de manière centralisée, au moins un dispositif de mesure du courant (3) dédié raccordé sur une des branches du réseau pour mesurer les courants sur ladite branche du réseau, lesdits dispositifs de mesure (2, 3) étant connectés entre eux par au moins une liaison de communication permettant la communication desdites mesures de tension audit dispositif de mesure du courant (3) lequel comporte au moins une unité de traitement (33) pour calculer ladite consommation énergétique de ladite branche du réseau analysée, **caractérisé en ce que** ledit dispositif de mesure des tensions (2) unique comporte des moyens (21, 24) pour effectuer lesdites mesures de tension du réseau par échantillonnage des tensions à un instant ($T_{v,n}$) à une première fréquence d'échantillonnage, **en ce que** ledit dispositif de mesure des tension (2) comporte des moyens pour transmettre les échantillons de tension audit dispositif de mesure du courant (3) via la liaison de communication à l'instant d'échantillonnage des tensions ($T_{v,n}$), **en ce que** ledit dispositif de mesure du courant (3) dédié comporte des moyens (31, 34) pour effectuer lesdites mesures du courant de la branche du réseau par échantillonnage des courants à un instant ($T_{i,n}$) à une seconde fréquence d'échantillonnage, **en ce que** ledit équipement de mesure comporte des moyens (35) pour comparer l'écart existant entre l'instant d'échantillonnage des tensions ($T_{v,n}$) et l'instant d'échantillonnage des courants ($T_{i,n}$) étant donné que lesdits dispositifs de mesure des tensions (2) et du courant (3) fonctionnent de manière asynchrone, et **en ce que** lesdits dispositifs de mesure des tensions (2) et du courant (3) comportent des moyens (23, 33) pour ajuster au moins une fréquence d'échantillonnage par rapport à l'autre pour ramener l'écart existant entre l'instant d'échantillonnage des tensions ($T_{v,n}$) et l'instant d'échantillonnage des courants ($T_{i,n}$) vers zéro.

**17.** Equipement de mesure selon la revendication 16, **caractérisé en ce que** ledit dispositif de mesure des tensions (2) comporte au moins un oscillateur ajustable (24) agencé pour définir ladite fréquence d'échantillonnage des mesures de tension, un module de fréquence (22) agencé pour mesurer ladite fréquence du réseau analysé, et au moins une unité de traitement (23) agencée pour traiter au moins lesdits échantillons de tension et les mesures de fréquence dudit réseau, ledit oscillateur ajustable (24) étant asservi par ladite unité de traitement (23).

**18.** Equipement de mesure selon la revendication 16, **caractérisé en ce que** ledit dispositif de mesure du courant (3) comporte au moins un oscillateur ajustable (34) agencé pour définir ladite fréquence d'échantillonnage des mesures de courant, au moins une unité de traitement (33) agencée pour calculer au moins l'énergie consommée par ladite branche du réseau à partir des échantillons de tension reçus par la liaison de communication et des échantillons de courant mesurés sur ladite branche, et un module de déphasage (35) agencé pour mesurer l'écart existant entre les instants d'échantillonnage des tensions ($T_{v,n}$) et les instants d'échantillonnage des courants ($T_{i,n}$) et pour asservir ledit oscillateur ajustable (34) afin d'ajuster la fréquence d'échantillonnage des mesures de courant pour la synchroniser sur la fréquence d'échantillonnage des mesures de tension.

19. Equipement de mesure selon l'une quelconque des revendications 16 à 18, **caractérisé en ce que** ladite liaison de communication est constituée d'au moins une paire de fils conducteurs, appelée paire de communication unidirectionnelle (63), prévue dans un câble réseau (6) pour transmettre les échantillons de tension sous forme numérique, et **en ce que** ledit câble réseau (6) est agencé pour connecter ledit dispositif de mesure des tensions (2) centralisé audit dispositif de mesure du courant (3) dédié par l'intermédiaire de connecteurs adaptés (60, 61).

20. Equipement de mesure selon la revendication 19, **caractérisé en ce que** ledit câble réseau (6) comporte une deuxième paire de fils conducteurs dédiée appelée paire d'alimentation (62) agencée pour amener une alimentation électrique auxdits dispositifs de mesure (2, 3).

21. Equipement de mesure selon l'une des revendications 19 ou 20, **caractérisé en ce que** ledit câble réseau (6) comporte une troisième paire de fils conducteurs dédiée appelée paire de communication bidirectionnelle (64) agencée pour connecter lesdits dispositifs de mesure (2, 3) à une unité de surveillance (S).

22. Equipement de mesure selon la revendication 19, **caractérisé en ce qu'**il comporte des moyens pour injecter un courant de défaut à la terre dans le réseau analysé, **en ce que** ledit dispositif de mesure du courant (3) comporte un capteur agencé pour mesurer ledit courant de défaut à la terre et **en ce que** ladite unité de traitement (33) est agencée pour déterminer l'impédance de fuite à la terre de ladite branche dudit réseau analysée à partir des échantillons de tension reçus par la paire de communication unidirectionnelle (63) et des échantillons de courant de fuite à la terre mesurés localement.

23. Equipement de mesure selon la revendication 18, **caractérisé en ce que** ledit dispositif de mesure du courant (3) comporte un capteur de tension auxiliaire agencé pour mesurer un signal auxiliaire représentatif de la tension du conducteur sur lequel ledit dispositif (3) mesure le courant, et **en ce que** ladite unité de traitement (33) comporte un module de corrélation agencé pour mettre en correspondance la mesure de tension avec la mesure de courant effectuée sur un même conducteur dudit réseau électrique (10).

24. Equipement de mesure selon la revendication 18, **caractérisé en ce que** ledit dispositif de mesure du courant (3) comporte en outre un capteur de tension pour mesurer la tension locale sur ladite branche du réseau analysée et **en ce que** ladite unité de traitement (33) est agencée pour calculer localement au moins ladite consommation d'énergie et la comparer avec ladite consommation d'énergie calculée à partir des mesures de tension centralisées pour évaluer les pertes énergétiques dans les câbles dudit réseau.

25. Equipement de mesure selon l'une quelconque des revendications 16 à 24, **caractérisé en ce qu'**il comporte au moins un autre dispositif de mesure des tensions (2) connecté à un autre réseau électrique (10) à analyser, et **en ce que** cet autre dispositif de mesure des tensions (2) est connecté audit dispositif de mesure des tensions (2) du réseau principal par ladite liaison de communication.

26. Equipement de mesure selon la revendication 16, **caractérisé en ce qu'**il comporte un nombre N de dispositifs de mesure de courant (3) dédiés correspondant au nombre N de branches du réseau électrique (10) à analyser, tous les dispositifs de mesure du courant (3) étant connectés audit dispositif de mesure des tensions (2) centralisé.

27. Equipement de mesure selon la revendication 19, **caractérisé en ce qu'**il comporte au moins un dispositif de terminaison de ligne (5) disposé à la fin de ladite paire de communication unidirectionnelle (63).

28. Equipement de mesure selon la revendication 16, **caractérisé en ce qu'**il comporte au moins un dispositif de connexion (4) disposé en amont des branches du réseau électrique à analyser et agencé pour faire l'interface électrique entre lesdits dispositifs de mesure (2, 3) d'une part et au moins une alimentation électrique (8) et une unité de supervision (S) d'autre part.

**Patentansprüche**

1. Verfahren zur Messung des Energieverbrauchs der Verzweigungen (11, 12, 13, N) eines elektrischen Netzwerks (10), Verfahren in dem man die Spannungen von besagtem Netzwerk auf zentralisierte Weise mit Hilfe einer einzigen den Verzweigungen des Netzwerks vorgeschalteten Spannungsmessvorrichtung (2) misst, man den Strom auf zumindest einer der Verzweigungen des Netzwerks mit Hilfe zumindest einer dedizierten Strommessvorrichtung (3) misst, man über eine Kommunikationsverbindung besagte Spannungsmessungen an besagte Strommessvorrichtung (3) übermittelt, und man in besagter Strommessvorrichtung (3) zumindest besagten Energieverbrauch von besagter analysierter Verzweigung des Netzwerks errechnet, **dadurch gekennzeichnet, dass** man die Spannungsmessungen von besagtem Netzwerk mit Hilfe von besagter einzigen Spannungsmessvorrichtung (2) durch Abtastung der Spannungen mit einer ersten Abtastfrequenz zu einem Zeitpunkt $(T_{v,n})$ durchführt, man die Spannungsproben zum Abtast-Zeitpunkt der Spannungen $(T_{v,n})$ über die Kommunikationsverbindung an besagte Strommessvorrichtung (3) übermittelt, man die Strommessungen der Verzweigung des Netzwerks mit Hilfe von besagter dedizierter Strommessvorrichtung (3) durch Abtastung der Ströme mit einer zweiten Abtastfrequenz zu einem Zeitpunkt $(T_{i,n})$ durchführt, man die bestehende Abweichung zwischen dem Zeitpunkt der Abtastung der Spannungen $(T_{v,n})$ und dem Zeitpunkt der Abtastung der Ströme $(T_{i,n})$ vergleicht, da besagte Vorrichtungen zur Messung der Spannungen (2) und des Stroms (3) asynchron arbeiten, und man zumindest eine Abtastfrequenz in Bezug auf die andere einstellt, um die Abweichung zwischen dem Zeitpunkt der Abtastung der Spannungen $(T_{v,n})$ und dem Zeitpunkt der Abtastung der Ströme $(T_{i,n})$ gegen Null zurück zu bringen.

2. Messverfahren nach Anspruch 1, **dadurch gekennzeichnet, dass** besagte Spannungsmessvorrichtung (2) einen Informationsrahmen mit Dauer (D) verwendet, um die Spannungsproben über die Kommunikationsverbindung zum Zeitpunkt der Abtastung der Spannungen $(T_{v,n})$ zu übermitteln, dadurch, dass die Strommessvorrichtung (3) diese Spannungsproben empfängt und den Zeitpunkt des Endes des Empfangs von besagtem Informationsrahmen $(T_{rec,n})$ erfasst, dadurch, dass die Strommessvorrichtung (3) den Zeitpunkt der Abtastung der Spannungen $(T_{v,n})$ errechnet, dadurch, dass die Strommessvorrichtung (3) die Abweichung $(\Delta T_n)$ zwischen dem Zeitpunkt der Abtastung der Ströme $(T_{1,n})$ und dem Zeitpunkt der Abtastung der Spannungen $(T_{v,n})$ errechnet, und dadurch, dass die Strommessvorrichtung (3) ihre eigene Abtast-Frequenz einstellt, um diese Abweichung gegen Null zurück zu bringen, durch Erhöhung der Abtast-Frequenz wenn die Abweichung $(\Delta T_n)$ positiv ist und durch Verringerung der Frequenz wenn die Abweichung $(\Delta T_n)$ negativ ist.

3. Messverfahren nach Anspruch 2, **dadurch gekennzeichnet, dass** besagte Spannungsmessvorrichtung (2) die Spannungsproben mit einer festen Verzögerung (R) in Bezug auf den Zeitpunkt der Abtastung der Spannungen $(T_{v,n})$ über die Kommunikationsverbindung sendet und dazu einen Informationsrahmen mit einer bekannten Dauer (D) verwendet, dadurch, dass die Strommessvorrichtung (3) den Zeitpunkt der Abtastung der Spannungen $(T_{v,n})$ auf der Grundlage der bekannten Daten (D) und (R) nach Formel: $T_{v,n}=T_{rec,n}-D-R$ errechnet, und dadurch, dass die Strommessvorrichtung (3) die Abweichung $(\Delta T_n)$ zwischen dem Zeitpunkt der Abtastung der Ströme $(T_{i,n})$ und dem Zeitpunkt der Abtastung der Spannungen $(T_{v,n})$ nach Formel $\Delta T_n = T_{i,n} - T_{v,n} = T_{i,n} - (T_{rec,n}+D+R)$ errechnet.

4. Verfahren nach Anspruch 1, **dadurch gekennzeichnet, dass** man besagte Kommunikationsverbindung verwendet, um zusätzliche Informationen von besagter Spannungsmessvorrichtung (2) an besagte Strommessvorrichtung (3) zu senden, wobei diese in der Gruppe bestehend aus dem Netzwerk-Typ, einphasig oder dreiphasig, mit oder ohne Neutral, der Nennspannung des Netzwerks, der Nennfrequenz des Netzwerks, Datum und Uhrzeit, Synchronisierimpulse für die Messung der Effektiv- und Leistungswerte, Ereigniserfassungsimpulse, gewählt werden.

5. Verfahren nach Anspruch 1, **dadurch gekennzeichnet, dass** man besagte Spannungsmessproben in Paketen von N Proben sendet.

6. Verfahren nach Anspruch 1, **dadurch gekennzeichnet, dass** man für die Spannungsmessungen eine feste Abtastfrequenz wählt.

7. Verfahren nach Anspruch 1, **dadurch gekennzeichnet, dass** man die Abtastfrequenz der Spannungsmessungen über die Frequenz des analysierten elektrischen Netzwerks (10) ansteuert.

8. Verfahren nach einem beliebigen der vorhergehenden Ansprüche, **dadurch gekennzeichnet, dass** man die Spannungsmessproben in numerischer Form über ein Netzwerkkabel (6) sendet, das mit besagter Strommessvorrichtung (3) verbunden ist, wobei dieses Netzwerkkabel (6) zumindest ein erstes, als Einweg-Kommunikationspaar (63) bezeichnetes Leiter-Paar beträgt

9. Verfahren nach Anspruch 8, **dadurch gekennzeichnet, dass** man dasselbe Netzwerk-Kabel (6) verwendet, um besagte Messvorrichtungen (2, 3) über ein zweites dediziertes, als Versorgungs-Paar (62) bezeichnetes Leiter-Paar elektrisch zu versorgen.

10. Verfahren nach einem der Ansprüche 8 oder 9, **dadurch gekennzeichnet, dass** man dasselbe Netzwerk-Kabel (6) verwendet, um besagte Messvorrichtungen (2, 3) über ein drittes dediziertes, als bidirektionales Kommunikationspaar (64) bezeichnetes Leiter-Paar mit einer Überwachungs-Einheit (S) zu verbinden.

11. Verfahren nach Anspruch 1, **dadurch gekennzeichnet, dass** man die Spannungen von besagtem elektrischen Netzwerk (10) in Bezug auf ein aus der Erde von besagtem Netzwerk bestehendes Bezugspotential misst, dadurch, dass man einen Erdfehlerstrom in das analysierte Netzwerk einspeist, dadurch, dass man besagten eingespeisten Fehlerstrom misst, und dadurch, dass man die Erdschluss-Impedanz von zumindest einer der Verzweigungen von besagtem analysierten Netzwerk bestimmt.

12. Verfahren nach Anspruch 1, **dadurch gekennzeichnet, dass** besagte Strommessvorrichtung (3) ein Hilfssignal liefert, das für die Spannung des Leiters, auf dem man den Strom misst, repräsentativ ist, wobei besagtes Hilfs-Spannungssignal verwendet wird, um die Spannungsmessung an die auf einem selben Leiter von besagtem elektrischen Netzwerk (10) durchgeführten Strommessung anzupassen und Anschlussfehler automatisch zu beheben.

13. Verfahren nach Anspruch 1, **dadurch gekennzeichnet, dass** besagte Strommessvorrichtung (3) ebenfalls die lokale Spannung auf besagter Verzweigung des Netzwerks misst, um lokal zumindest besagten Energieverbrauch zu errechnen und diesen mit besagtem von den zentralisierten Spannungsmessungen ausgehend errechneten Energieverbrauch zu vergleichen, um die Energieverluste in besagtem Netzwerk zu schätzen.

14. Verfahren nach einem beliebigen der vorhergehenden Ansprüche, **dadurch gekennzeichnet, dass** man zumindest eine weitere, mit einem anderen zu analysierenden elektrischen Netzwerk verbundene Spannungsmessvorrichtung (2) verwendet, dadurch, dass man einer der Spannungsmessvorrichtungen (2) die von der anderen Spannungsmessvorrichtung (2) erhaltenen Spannungsmessproben über besagte Kommunikationsverbindung zusendet, und dadurch, dass man Amplitude und Phase der beiden analysierten elektrischen Netzwerke vergleicht, um sie zusammen zu schließen wenn die Unterschiede gering genug sind.

15. Verfahren nach Anspruch 14, **dadurch gekennzeichnet, dass**, wenn die beiden elektrischen Netzwerke (10) zusammen geschlossen sind, eine beliebige der Spannungsmessvorrichtungen (2) die Kontrolle über die Kommunikationsverbindung übernimmt und verwendet wird, um die Spannungen von besagtem entsprechenden Netzwerk zu messen.

16. Vorrichtung zur Messung des Energieverbrauchs der Verzweigungen (11, 12, 13, N) eines elektrischen Netzwerks (10), die das Messverfahren nach einem beliebigen der vorhergehenden Ansprüche einsetzt, Vorrichtung bestehend aus einer einzigen den zu analysierenden Verzweigungen des Netzwerks vorgeschalteten Spannungsmessvorrichtung (2), um die Spannungen von besagtem Netzwerk zentral zu messen, zumindest eine dedizierte Strommessvorrichtung (3), die an einer der Verzweigungen des Netzwerks angeschlossen ist, um die Ströme auf besagter Verzweigung des Netzwerks zu messen, wobei besagte Messvorrichtungen (2, 3) über zumindest eine Kommunikationsverbindung miteinander verbunden sind, die die Übermittlung von besagten Spannungsmessungen an besagte Strommessvorrichtung (3) ermöglicht, welche zumindest eine Verarbeitungseinheit (33) beträgt, um besagten Energieverbrauch von besagter analysierter Verzweigung des Netzwerks zu errechnen, **dadurch gekennzeichnet, dass** besagte einzige Spannungsmessvorrichtung (2) Mittel (21, 24) beträgt, um besagte Netzwerk-Spannungsmessungen durch Abtastung der Spannungen mit einer ersten Abtastfrequenz zu einem Zeitpunkt ($T_{v,n}$) durchzuführen, dadurch, dass besagte Spannungsmessvorrichtung (2) Mittel beträgt, um die Spannungsproben zum Zeitpunkt der Abtastung der Spannungen ($T_{v,n}$) über besagte Kommunikationsverbindung an besagte Strommessvorrichtung (3) zu senden, dadurch, dass besagte dedizierte Strommessvorrichtung (3) Mittel (31, 34) beträgt, um besagte Strommessungen an der Verzweigung des Netzwerks mit einer zweiten Abastfrequenz zu einem Zeitpunkt ($T_{i,n}$) durchzuführen, dadurch, dass besagte Messvorrichtung Mittel (35) beträgt, um die bestehende Abweichung zwischen dem Zeitpunkt der Abtastung der Spannungen ($T_{v,n}$) und dem Zeitpunkt der Abtastung der Ströme ($T_{i,n}$) zu vergleichen, da besagte Vorrichtungen zur Messung der Spannungen (2) und des Stroms (3) asynchron arbeiten, und dadurch, dass besagte Vorrichtungen zur Messung der Spannungen (2) und des Stroms (3) Mittel (23, 33) betragen, um zumindest eine Abtastfrequenz in Bezug auf die andere einzustellen, um die Abweichung zwischen dem Zeitpunkt der Abtastung der Spannungen ($T_{v,n}$) und dem Zeitpunkt der Abtastung der Ströme ($T_{i,n}$) gegen Null zurück zu bringen.

17. Messvorrichtung nach Anspruch 16, **dadurch gekennzeichnet, dass** besagte Spannungsmessvorrichtung (2) zumindest einen einstellbaren Oszillator (24) beträgt, der ausgelegt ist, um besagte Abtast-Frequenz der Spannungsmessungen zu bestimmen, sowie ein Frequenz-Modul (22), das ausgelegt ist, um besagte Frequenz des analysierten Netzwerks zu messen, und zumindest eine Verarbeitungs-Einheit (23), die ausgelegt ist, um zumindest besagte Spannungsproben und Frequenzmessungen von besagtem Netzwerk zu verarbeiten, wobei besagter einstellbarer Oszillator (24) von besagter Verarbeitungs-Einheit (23) angesteuert wird.

18. Messvorrichtung nach Anspruch 16, **dadurch gekennzeichnet, dass** besagte Strommessvorrichtung (3) zumindest einen einstellbaren Oszillator (34) beträgt, der ausgelegt ist, um besagte Abtast-Frequenz der Strommessungen zu bestimmen, sowie zumindest eine Verarbeitungs-Einheit (33), die ausgelegt ist, um auf der Grundlage der über die Kommunikationsverbindung erhaltenen Spannungsproben und der auf besagter Verzweigung gemessenen Stromproben zumindest die von besagter Verzweigung des Netzwerks verbrauchte Energie zu errechnen, und ein Phasenverschiebungsmodul (35), das ausgelegt ist, um die zwischen den Spannungs-Abtastzeitpunkten $(T_{v,n})$ und den Strom-Abtastzeitpunkten $(T_{i,n})$ bestehende Abweichung zu messen und um besagten einstellbaren Oszillator (34) anzusteuern, um die Abtast-Frequenz der Strommessungen einzustellen, um diese mit der Abtast-Frequenz der Spannungsmessungen zu synchronisieren.

19. Messvorrichtung nach einem beliebigen der Ansprüche 16 bis 18, **dadurch gekennzeichnet, dass** besagte Kommunikationsverbindung aus zumindest einem in einem Netzwerk-Kabel (6) vorgesehenen, als Einweg-Kommunikationspaar (63) bezeichneten Leiter-Paar besteht, um die Spannungsproben in numerischer Form weiterzuleiten, und dadurch, dass besagtes Netzwerk-Kabel (6) ausgelegt ist, um besagte zentralisierte Spannungsmessvorrichtung (2) über geeignete Steckverbinder (60, 61) mit besagter dedizierter Strommessvorrichtung (3) zu verbinden.

20. Messvorrichtung nach Anspruch 19, **dadurch gekennzeichnet, dass** besagtes Netzwerk-Kabel (6) ein zweites dediziertes, als Versorgungs-Paar (62) bezeichnetes Leiter-Paar beträgt, das ausgelegt ist, um besagte Messvorrichtungen (2, 3) elektrisch zu versorgen.

21. Messvorrichtung nach einem der Ansprüche 19 oder 20, **dadurch gekennzeichnet, dass** besagtes Netzwerk-Kabel (6) ein drittes dediziertes, als bidirektionales Kommunikationspaar (64) bezeichnetes Leiter-Paar beträgt, das ausgelegt ist, um besagte Messvorrichtungen (2, 3) mit einer Überwachungs-Einheit (S) zu verbinden.

22. Messvorrichtung nach Anspruch 19, **dadurch gekennzeichnet, dass** sie Mittel beträgt, um einen Erdfehlerstrom in das analysierte Netzwerk einzuspeisen, dadurch, dass besagte Strommessvorrichtung (3) einen Sensor beträgt, der ausgelegt ist, um besagten Erdstrom zu messen, und dadurch, dass besagte Verarbeitungs-Einheit (33) ausgelegt ist, um auf der Grundlage der über das Einweg-Kommunikationspaar (63) erhaltenen Spannungsproben und der lokal gemessenen Erdstromproben die Erdschluss-Impedanz von besagter Verzweigung von besagtem analysierten Netzwerk zu bestimmen.

23. Messvorrichtung nach Anspruch 18, **dadurch gekennzeichnet, dass** besagte Strommessvorrichtung (3) einen Hilfs-Stromsensor beträgt, der ausgelegt ist, um ein für die Spannung des Leiters, auf dem besagte Vorrichtung (3) den Strom misst, repräsentatives Hilfssignal zu messen, und dadurch, dass besagte Verarbeitungs-Einheit (33) ein Korrelationsmodul beträgt, das ausgelegt ist, um die Spannungsmessung mit der auf einem selben Leiter von besagtem elektrischen Netzwerk (10) durchgeführten Strommessung abzugleichen.

24. Messvorrichtung nach Anspruch 18, **dadurch gekennzeichnet, dass** besagte Strommessvorrichtung (3) zudem einen Spannungssensor beträgt, um die lokale Spannung auf besagter analysierter Verzweigung des Netzwerks zu messen, und dadurch, dass besagte Verarbeitungs-Einheit (33) ausgelegt ist, um lokal zumindest besagten Energieverbrauch zu errechnen und diesen mit besagtem von den zentralisierten Spannungsmessungen ausgehend errechneten Energieverbrauch zu vergleichen, um die Energieverluste in den Kabeln von besagtem Netzwerk zu schätzen.

25. Messvorrichtung nach einem beliebigen der Ansprüche 16 bis 24, **dadurch gekennzeichnet, dass** sie zumindest eine weitere, mit einem anderen zu analysierenden elektrischen Netzwerk (10) verbundene Spannungsmessvorrichtung (2) beträgt, und dadurch, dass diese weitere Spannungsmessvorrichtung (2) über besagte Kommunikationsverbindung mit besagter Spannungsmessvorrichtung (2) des Haupt-Netzwerks verbunden ist.

26. Messvorrichtung nach Anspruch 16, **dadurch gekennzeichnet, dass** sie eine Anzahl N von dedizierten Strommessvorrichtungen (3) beträgt, die der Anzahl N von Verzweigungen des zu analysierenden elektrischen Netzwerks (10) entspricht, wobei alle Strommessvorrichtungen (3) mit besagter zentralisierter Spannungsmessvorrichtung (2) verbunden sind.

27. Messvorrichtung nach Anspruch 19, **dadurch gekennzeichnet, dass** sie zumindest eine am Ende von besagtem Einweg-Kommunikationspaar (63) angeordnete Leitungsabschluss-Vorrichtung (5) beträgt.

28. Messvorrichtung nach Anspruch 16, **dadurch ge-**

**kennzeichnet, dass** sie zumindest eine den zu analysierenden Verzweigungen des elektrischen Netzwerks vorgeschaltete Verbindungsvorrichtung (4) beträgt, die ausgelegt ist, um als elektrische Schnittstelle zwischen besagten Messvorrichtungen (2, 3) einerseits und zumindest einer Stromversorgung (8) und einer Überwachungs-Einheit (S) andererseits zu dienen.

**Claims**

1. Method for measuring the energy consumption of the branches (11, 12, 13, N) of an electrical network (10), method in which one measures the voltages of said network in a centralized manner by means of a single voltages measuring device (2) connected upstream of the branches of the network, one measures the current on at least one of the branches of the network by means of a dedicated current measuring device (3), one communicates through a communication link said voltage measurements to said current measuring device (3), and one calculates in said current measuring device (3) at least said energy consumption of said analyzed branch of the network, **characterized in that** one performs the measurements of the voltages of said network by means of said single voltages measuring device (2) by sampling the voltages at a moment ($T_{v,n}$) at a first sampling frequency, one transmits the voltage samples to said current measuring device (3) through the communication link at the moment the voltages are sampled ($T_{v,n}$), one performs the measurements of the current of the branch of the network by means of said dedicated current measuring device (3) by sampling the currents at a moment ($T_{i,n}$) at a second sampling frequency, one compares the time difference existing between the sampling moment of the voltages ($T_{v,n}$) and the sampling moment of the currents ($T_{i,n}$) since said voltage (2) and current (3) measuring devices operate asynchronously, and one adjusts at least one sampling frequency with respect to the other to bring the time difference existing between the sampling moment of the voltages ($T_{v,n}$) and the sampling moment of the currents ($T_{i,n}$) close to zero.

2. Method for measuring according to claim 1, **characterized in that** said voltages measuring device (2) transmits the voltage samples on the communication link at voltages sampling moment ($T_{v,n}$) using an information frame of duration (D), **in that** current measuring device (3) receives these voltage samples and detects the moment of the end of the reception of said information frame ($T_{rec,n}$), **in that** current measuring device (3) calculates the voltages sampling moment ($T_{v,n}$), **in that** current measuring device (3) calculates the time difference ($\Delta T_n$) between the currents sampling moment ($T_{i,n}$) and the voltages sampling moment ($T_{v,n}$), and **in that** current measuring device (3) adjusts its own sampling frequency in order to bring this time difference close to zero by increasing the sampling frequency if the time difference ($\Delta T_n$) is positive and reducing it if the time difference ($\Delta T_n$) is negative.

3. Method for measuring according to claim 2, **characterized in that** said voltages measurement device (2) transmits the voltage samples on the communication link with a fixed delay (R) with respect to the voltages sampling moment ($T_{v,n}$) using an information frame of a known duration (D), **in that** current measurement device (3) calculates the voltages sampling moment ($T_{v,n}$) from the known data (D) and (R) according to the formula: $T_{v,n}=T_{rec,n}-D-R$, and **in that** current measurement device (3) calculates the time difference ($\Delta T_n$) between the currents sampling moment ($T_{i,n}$) and the voltages sampling moment ($T_{v,n}$) according to the formula $\Delta T_n=T_{i,n} - T_{v,n}= T_{i,n} - (T_{rec,n}+D+R)$.

4. Method according to claim 1, **characterized in that** one uses said communication link to transmit from said voltages measuring device (2) to said current measuring device (3) additional information chosen in the group comprising the single-phase or three-phase network type, with or without neutral, the rated voltage of the network, the rated frequency of the network, date and time, synchronization pulses of effective and power values measurements, event capture signals.

5. Method according to claim 1, **characterized in that** one transmits said voltage measurement samples in packets of N samples.

6. Method according to claim 1, **characterized in that** one chooses a fixed sampling frequency of the voltage measurements.

7. Method according to claim 1, **characterized in that** one controls the sampling frequency of the voltage measurements by the frequency of the analyzed electrical network (10).

8. Method according to any of the previous claims, **characterized in that** one transmits the voltage measurement samples in digital form on a network cable (6) connected to said current measuring device (3), this network cable (6) comprising at least a first pair of conductive wires called unidirectional communication pair (63).

9. Method according to claim 8, **characterized in that** one uses the same network cable (6) to provide an electrical power supply to said measuring devices (2, 3) using a second dedicated pair of conductive wires called power supply pair (62).

10. Method according to any of claims 8 or 9, **characterized in that** one uses the same network cable (6) to connect said measuring devices (2, 3) to a monitoring unit (S) by means of a third dedicated pair of conductive wires called bidirectional communication pair (64).

11. Method according to claim 1, **characterized in that** one measures the voltages of said electrical network (10) with respect to a reference potential formed by the earth of said network, **in that** one injects an earth fault current in the analyzed network, **in that** one measures said injected fault current and **in that** one determines the earth leakage impedance of at least one of the branches of said analyzed network.

12. Method according to claim 1, **characterized in that** said current measuring device (3) supplies an auxiliary signal representative of the voltage of the conductor on which the current is measured, said auxiliary voltage signal being used for matching the voltage measurement with the current measurement performed on a same conductor of said electrical network (10) and compensate automatically for connection errors.

13. Method according to claim 1, **characterized in that** said current measuring device (3) also measures the local voltage on said network branch to calculate locally at least said energy consumption and compare it with said energy consumption calculated from the centralized voltage measurements to evaluate the energy losses in said network.

14. Method according to any of the previous claims, **characterized in that** one uses at least one other voltages measuring system (2) connected to another electrical network to be analyzed, **in that** one transmits to one of the voltages measuring devices (2), through said communication link, the voltage measurement samples obtained by the other voltages measuring device (2) and **in that** one compares the amplitude and the phase of both analyzed electrical networks to connect them together when said differences are sufficiently low.

15. Method according to claim 14, **characterized in that**, when both electrical networks (10) are connected together, any one of the voltages measuring devices (2) takes the control of the communication link and is used for measuring the voltages of said corresponding network.

16. Measuring equipment for the energy consumption of the branches (11, 12, 13, N) of an electrical network (10) implementing the measuring method according to any of the previous claims, comprising a single voltages measuring device (2) connected upstream of the branches of the network to be analyzed so as to measure the voltages of said network in a centralized manner, at least one dedicated current measuring device (3) connected to one of the branches of the network so as to measure the currents on said branch of the network, said measuring devices (2, 3) being connected to each other by at least one communication link allowing communicating said voltage measurements to said current measuring device (3), which comprises at least one processing unit (33) for calculating said energy consumption of said analyzed branch of the network, **characterized in that** said single voltages measuring device (2) comprises means (21, 24) to perform said network voltage measurements by sampling the voltages at a moment ($T_{v,n}$) at a first sampling frequency, **in that** said voltages measuring device (2) comprises means for transmitting the voltage samples to said current measuring device (3) through the communication link at voltages sampling moment ($T_{v,n}$), **in that** said dedicated current measuring device (3) comprises means (31, 34) to perform said measurements of the current of the network branch by sampling the currents at a moment ($T_{i,n}$) at a second sampling frequency, **in that** said measuring equipment comprises means (35) to compare the time difference existing between the sampling moment of the voltages ($T_{v,n}$) and the sampling moment of the currents ($T_{i,n}$), since said voltages (2) and current (3) measuring devices operate asynchronously, and **in that** said voltages (2) and current (3) measuring devices comprise means (23, 33) to adjust at least one sampling frequency with respect to the other to bring the time difference existing between the sampling moment of the voltages ($T_{v,n}$) and the sampling moment of the currents ($T_{i,n}$) close to zero.

17. Measuring equipment according to claim 16, **characterized in that** said voltages measuring device (2) comprises at least one adjustable oscillator (24) arranged to define said sampling frequency of the voltage measurements, a frequency module (22) arranged to measure said frequency of the analyzed network and at least one processing unit (23) arranged to process at least said voltage samples and the frequency measurements of said network, said adjustable oscillator (24) being controlled by said processing unit (23).

18. Measuring equipment according to claim 16, **characterized in that** said current measuring device (3) comprises at least one adjustable oscillator (34) arranged to define said current measurement sampling frequency, at least one processing unit (33) arranged to calculate at least the energy consumed by said branch of the network from the voltage samples received through the communication link and from the current samples measured on said branch, and a phase shift module (35) arranged to measure the time difference existing between the voltages sampling moments ($T_{v,n}$) and the currents sampling moments ($T_{i,n}$) and to control said adjustable oscillator (34) in order to adjust the current measurements sampling frequency so as to synchronize it with the voltage measurements sampling frequency.

19. Measuring equipment according to any of claims 16 to 18, **characterized in that** said communication link is made of at least one pair of conductive wires called unidirectional communication pair (63) provided in a network cable (6) to transmit the voltage samples in digital form, and **in that** said network cable (6) is arranged to connect said centralized voltages measuring device (2) to said dedicated current measuring device (3) through suitable connectors (60, 61).

20. Measuring equipment according to claim 19, **characterized in that** said network cable (6) comprises a second dedicated pair of conductive wires called power supply pair (62) arranged to provide an electrical power supply to said measuring devices (2, 3).

21. Measuring equipment according to one of claims 19 or 20, **characterized in that** said network cable (6) comprises a third dedicated pair of conductive wires called bidirectional communication pair (64) arranged to connect said measuring units (2, 3) to a monitoring unit (S).

22. Measuring equipment according to claim 19, **characterized in that** it comprises means for injecting an earth fault current in the analyzed network, **in that** said current measuring device (3) comprises a sensor arranged to measure said earth fault current and **in that** said processing unit (33) is arranged to determine the earth leakage impedance of said analyzed branch of said network based on the voltage samples received through the unidirectional communication pair (63) and from the earth leakage current samples measured locally.

23. Measuring equipment according to claim 18, **characterized in that** said current measuring device (3) comprises an auxiliary voltage sensor arranged to measure an auxiliary signal representative of the voltage of the conductor on which said device (3) measures the current, and **in that** said processing unit (33) comprises a correlation module arranged to match the voltage measurement with the current measurement performed on a same conductor of said electrical network (10).

24. Measuring equipment according to claim 18, **characterized in that** said current measuring device (3) moreover comprises a voltage sensor to measure the local voltage on said analyzed branch of the network and **in that** said processing unit (33) is arranged to calculate locally at least said energy consumption and compare it with said energy consumption calculated from the centralized voltage measurements to evaluate the energy losses in the cables of said network.

25. Measuring equipment according to any of claims 16 to 24, **characterized in that** it comprises at least one other voltages measuring device (2) connected to another electrical network (10) to be analyzed, and **in that** this other voltages measuring device (2) is connected to said main network voltages measuring device (2) through said communication link.

26. Measuring equipment according to claim 16, **characterized in that** it comprises a number N of dedicated current measuring devices (3) corresponding to the number N of branches of the electrical network (10) to be analyzed, all current measuring devices (3) being connected to said centralized voltages measuring device (2).

27. Measuring equipment according to claim 19, **characterized in that** it comprises at least one line termination device (5) located at the end of said unidirectional communication pair (63).

28. Measuring equipment according to claim 16, **characterized in that** it comprises at least one connection device (4) located upstream of the branches of the electrical network to be analyzed and arranged to act as the electrical interface between said measuring devices (2, 3) on the one hand and at least a power supply (8) and a supervision unit (S) on the other hand.

FIG. 1

FIG. 2

FIG. 3

FIG. 4

FIG. 5

FIG. 7

FIG. 6A

FIG. 6B

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6330516 B1
- EP 0853364 A2
- EP 1010015 B1